Europäisches Patentamt

European Patent Office

Office européen des brevets

(11) Publication number: **0 323 813**

**A1**

## EUROPEAN PATENT APPLICATION

(21) Application number: **88830499.5**

(22) Date of filing: **22.11.88**

(51) Int. Cl.4: **H02H 5/04** , **H02H 9/02**

(30) Priority: **29.12.87 IT 6814087**

(43) Date of publication of application:
**12.07.89 Bulletin 89/28**

(84) Designated Contracting States:
**AT BE CH DE ES FR GB GR IT LI LU NL SE**

(71) Applicant: **MARELLI AUTRONICA S.p.A.**
**Piazza Sant'Ambrogio, 6**
**I-20123 Milano(IT)**

(72) Inventor: **Ciliberto, Giuseppe**
**Via Lancia, 138/10**
**I-10141 Torino(IT)**

(74) Representative: **Quinterno, Giuseppe et al**
**c/o Jacobacci-Casetta & Perani S.p.A. Via**
**Alfieri, 17**
**I-10121 Torino(IT)**

(54) A device for the thermal protection of an integrated electronic power circuit.

㊐ The device is intended for the thermal protection of an integrated electronic power circuit (1) including at least one output power transistor (3). The device comprises:

a sensor (6) integrated in the circuit (1) and adapted to provide an output signal indicative of the temperature of the integrated circuit (1),

a sensor (5) of the current flowing in the collector-emitter path of the transistor (3), also integrated in the circuit (1), and

a control circuit device (7, 8), also integrated in the circuit (1), which is connected to the temperature sensor (6) and to the current sensor (5) and is arranged to cause a reduction in the base current of the power transistor (3) when the current in the collector-emitter path of the said transistor (3) exceeds a threshold value which is a decreasing function of the temperature.

FIG. 1

## A device for the thermal protection of an integrated electronic power circuit

The invention relates to a device for the thermal protection of an integrated electronic circuit including at least one output power transistor.

A thermal switch is usually incorporated in integrated circuits of this type for "quenching" the output transistor when the temperature exceeds a threshold value and for re-enabling operation of the transistor when the temperature falls below the threshold again.

Such a solution is certainly acceptable in various fields of use, for example, in the audio equipment sector.

This solution is not acceptable, however, in some fields, for example, in electronic systems for controlling the operation of internal combustion engines. Indeed, in these applications, it is not acceptable that the operation of an electronic control unit may fail, even momentarily.

The object of the present invention is to produce a thermal protection device for an integrated electronic power circuit which resolves the problems intrinsic in the known solution described above and which is therefore particularly applicable in the automotive electronics sector.

According to the invention, this object is achieved by means of a device characterised in that it comprises:

a sensor integrated in the circuit and adapted to provide an output signal indicative of the temperature of the integrated circuit,

a sensor of the current flowing in the collector-emitter path of the transistor, also integrated in the circuit, and

a control circuit device, also integrated in the circuit, which is connected to the temperature sensor and to the current sensor and is arranged to cause a reduction in the base current of the power transistor when the current in the collector-emitter path of the transistor exceeds a threshold value which is a decreasing function of the temperature.

Further characteristics and advantages of the device according to the invention will become clear from the description which follows with reference to the appended drawings, provided purely by way of non-limiting example, in which:

Figure 1 is a circuit diagram of an integrated circuit provided with a thermal protection device according to the invention, and

Figures 2 and 3 show two possible traces of a threshold signal generated by the thermal protection device according to the invention as a function of the temperature.

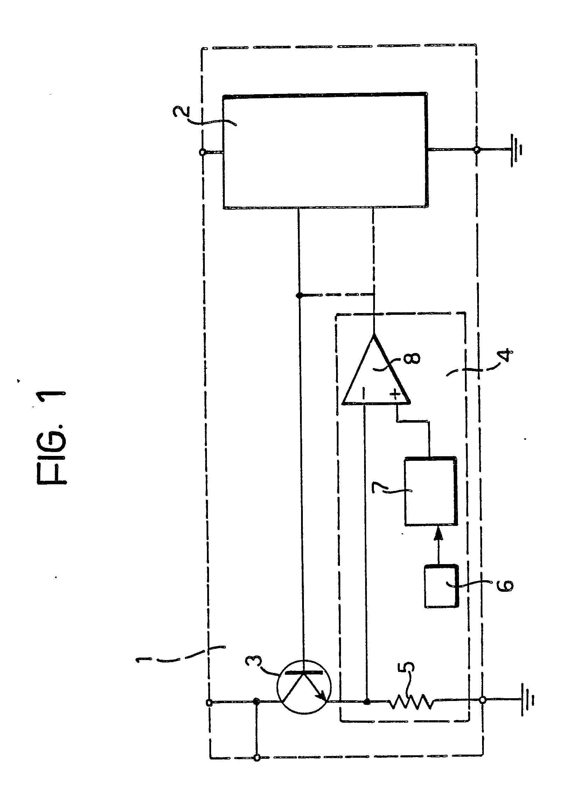

In Figure 1, an integrated electronic power circuit is generally indicated 1 and includes a circuit part 2, which is not described further and is intended to carry out a particular function, and (at least) one output power transistor, indicated 3. The transistor 3 in the drawing is of the npn type but may also be of the pnp type. Moreover, it could be constituted by a pair of transistors connected in a Darlington arrangement.

A thermal protection circuit device according to the invention is generally indicated 4 and is likewise integrated in the circuit 1. This protection device includes a resistor 5 connected to the collector-emitter path of the output transistor 3 so that, in operation, the voltage drop between its ends is indicative of the current flowing in the collector-emitter path of the transistor.

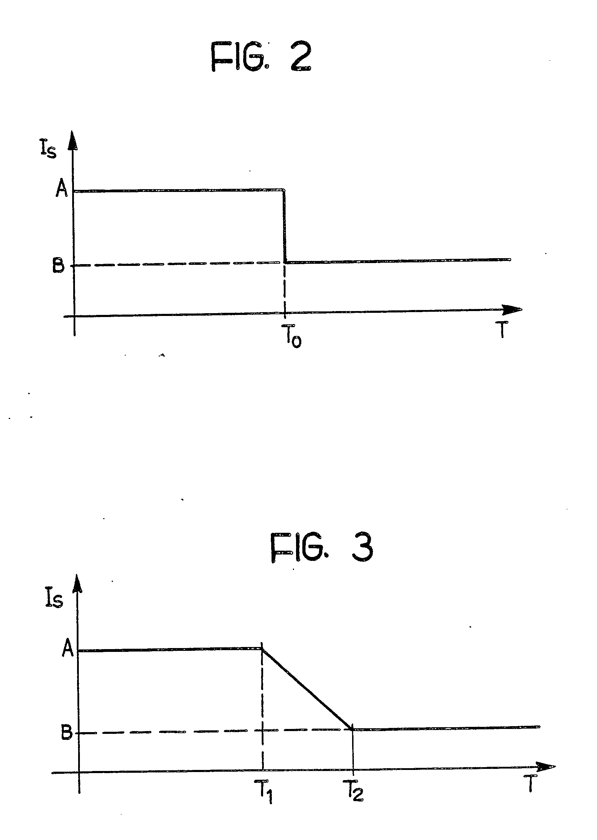

The protection device also includes a temperature sensor 6 (constituted, for example, by a pn junction) connected to the input of a threshold-signal generator circuit 7. This generator circuit is arranged to produce a threshold signal $I_s$ which is a decreasing function of the temperature, for example, according to the specimen traces shown in Figures 2 and 3.

A control circuit, indicated 8, is connected to the resistor 5 and to the threshold-signal generator circuit 7. The output of this control circuit may be connected either to the base of the transistor 3 or to a control input of the circuit part 2 of the integrated circuit 1, so as to cause a reduction in the current supplied to the base of the transistor 3 when the current flowing in its collector-emitter path exceeds the threshold value generated by the circuit 7.

The threshold signal generated by the circuit 7 may, for example, behave as shown in Figure 2: this signal assumes a first constant level A when the temperature T is less than a predetermined value $T_0$ (equal to 150° for example) and a second lower level B when the temperature exceeds $T_0$.

Alternatively, the behaviour of the threshold signal $I_s$ could be that shown in Figure 3: below a temperature $T_1$ and above a temperature $T_2$ (greater than $T_1$), the threshold signal assumes the levels A and B (the latter being less than A); at temperatures between $T_1$ and $T_2$, the trace of the signal $I_s$ decreases rapidly, for example linearly.

The device according to the invention enables effective thermal protection of an integrated electronic circuit of the above type to be achieved without the complete failure of the function performed by the integrated circuit when the temperature exceeds a given limit.

## Claims

1. A device for the thermal protection of an integrated electronic circuit (1) including at least one output power transistor (3),
characterised in that it comprises:
a sensor (6) integrated in the circuit (1) and adapted to provide an output signal indicative of the temperature of the integrated circuit (1),
a sensor (5) of the current flowing in the collector-emitter path of the said transistor (3), also integrated in the circuit (1); and
a control circuit device (7, 8), also integrated in the circuit (1), which is connected to the temperature sensor (6) and to the current sensor (5) and is arranged to cause a reduction in the base current of the said power transistor (3) when the current in the collector-emitter path thereof exceeds a threshold value which is a decreasing function of the temperature(T).

2. A device according to Claim 1, characterised in that the control circuit device (7, 8) comprises a signal-generator circuit (7) connected to the temperature sensor (6) and adapted to provide a threshold signal ($I_s$) which assumes a first constant level (A) when the temperature (T) is less than a first predetermined value ($T_0$; $T_1$) and a second lower constant level (B) when the temperature (T) is greater than a second predetermined value ($T_0$; $T_2$).

3. A device according to Claim 2, characterised in that the first predetermined temperature value ($T_0$) is substantially equal to the second predetermined value ($T_0$) (Figure 2).

4. A device according to Claim 2, characterised in that the second temperature value ($T_2$) is greater than the first ($T_1$) and in that, between these temperature values ($T_1$, $T_2$), the threshold signal ($I_s$) decreases rapidly as a function of the temperature (T).

5. A device according to Claim 4, characterised in that the trace of the threshold signal ($I_s$) is substantially linear between the temperature values ($T_1$, $T_2$).

6. A device according to any one of the preceding claims, characterised in that the temperature sensor (6) comprises a pn-type junction.

7. A device according to any one of the preceding claims, characterised in that the current sensor comprises a resistor (5) in series with the collector-emitter path of the transistor (3).

FIG. 1

# FIG. 2

# FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IEEE JOURNAL OF SOLID STATE CIRCUITS vol. SC-13, no. 3, June 1978, page 307-319; B. MURARI:"Power Integrated Circuits: Problems, Tradeoffs, and Solutions." * page 310; figure 8; page 311; figure 9; page 313; figure 313 * | 1,2,6,7 | H 02 H 5/04<br>H 02 H 9/02 |
| A | US-A-4 698 655 (W.J. SCHULTZ) * abstract, figures 1,2 * | 1-7 | |
| A | US-A-3 691 426 (R.J. MANKOWITZ) * column 4, line 37 - column 5, line 31; figure * | 3-5 | |
| A | US-A-3 876 914 (ST.J. LUKAS) * figure 1 * | 1 | |
| A | DE-B-2 246 385 (SIEMENS) * claim 1; figures 1,2 * | 1 | |

|  |  |  | TECHNICAL FIELDS SEARCHED (Int. Cl.4) |
|---|---|---|---|
|  |  |  | H 01 L 27/02<br>H 02 H 5/04<br>H 02 H 9/02 |

The present search report has been drawn up for all claims

| Place of search | Date of completion of the search | Examiner |
|---|---|---|
| BERLIN | 16-03-1989 | LEMMERICH J |